(19) Europäisches Patentamt / European Patent Office / Office européen des brevets

(11) **EP 2 880 708 B1**

(12) **FASCICULE DE BREVET EUROPEEN**

(45) Date de publication et mention
de la délivrance du brevet:
**31.05.2017 Bulletin 2017/22**

(21) Numéro de dépôt: **13745666.1**

(22) Date de dépôt: **06.08.2013**

(51) Int Cl.:
*H01M 10/48* *(2006.01)*   *G01R 31/36* *(2006.01)*

(86) Numéro de dépôt international:
**PCT/EP2013/066434**

(87) Numéro de publication internationale:
**WO 2014/023711 (13.02.2014 Gazette 2014/07)**

(54) **PROCEDE DE GESTION ET DIAGNOSTIC D'UNE BATTERIE**

VERFAHREN ZUR VERWALTUNG UND DIAGNOSE EINER BATTERIE

METHOD FOR MANAGING AND DIAGNOSING A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.08.2012 FR 1257633**

(43) Date de publication de la demande:
**10.06.2015 Bulletin 2015/24**

(73) Titulaire: **Commissariat à l'Énergie Atomique
et aux Énergies Alternatives
75015 Paris (FR)**

(72) Inventeur: **MONTARU, Maxime
F-73000 Chambery (FR)**

(74) Mandataire: **Novaimo
ActiTech 8
60 avenue Marie Curie
Archamps Technopole
74166 Saint Julien en Genevois Cedex (FR)**

(56) Documents cités:
**EP-A1- 1 686 389      WO-A1-2007/048366
US-A- 5 539 318      US-A- 5 561 362
US-A1- 2003 057 918**

**Description**

L'invention concerne un procédé de gestion d'une batterie, comprenant notamment la réalisation du diagnostic de la batterie, l'indication de l'état de charge et de l'état de santé de la batterie, pour maîtriser l'évolution de son état avec le temps, son vieillissement. Elle concerne aussi une batterie en tant que telle comprenant un agencement permettant de mettre en oeuvre ce procédé de gestion. Enfin, elle concerne aussi un système de gestion de batterie mettant en oeuvre ce procédé de gestion de batterie.

La connaissance de l'état d'une batterie comprend notamment le calcul de son état de charge à tout moment de son existence, indispensable pour pouvoir l'utiliser de manière optimale. Ce calcul de l'état de charge nécessite de connaître la capacité de référence de la batterie, appelée Cref. Cette capacité de référence représente la quantité de charge maximale que la batterie, initialement chargée, peut restituer au cours d'une décharge; la charge et la décharge sont effectuées dans des conditions nominales (régimes ou profil de courant, température, critères de fin de charge et de décharge). Cette capacité de référence diminue avec le temps, puisqu'avec son vieillissement, la batterie devient moins performante. Il est ainsi habituel de procéder régulièrement à une décharge complète de la batterie puis à une charge complète, durant laquelle la quantité de charge restituée et stockée par la batterie est mesurée, pour en déduire la nouvelle valeur de la capacité de référence à l'instant choisi. Ces phases de mesure et diagnostic de la batterie se font en général dans un environnement choisi et connu, notamment à une température constante et à un régime de courant imposé, c'est-à-dire un régime proche de conditions nominales. Ces solutions sont donc mal adaptées pour la gestion de batteries embarquées pour lesquelles le fonctionnement doit être fiable et connu dans un environnement non maîtrisé et très variable.

Pour affiner cette méthode d'estimation de l'état de charge d'une batterie, le document US2007/0236183 propose une solution qui permet de tenir compte notamment de la diminution de la capacité de référence d'une batterie avec le temps, et de sa dépendance envers la température, cette dépendance étant considérée connue. Ce document détermine ainsi une valeur d'état de charge d'une batterie à partir d'une phase de charge ou décharge complète de la batterie, en appliquant une légère correction par rapport à la méthode décrite précédemment. Le résultat obtenu reste toutefois insuffisant.

Ainsi, un objet général de l'invention est de proposer une solution de gestion d'une batterie qui permet d'améliorer son diagnostic, notamment la connaissance de son état, malgré un environnement non maîtrisé, pour en déduire une estimation précise à tout instant et à tout âge de son état de charge.

A cet effet, l'invention repose sur un procédé de gestion d'une batterie caractérisé en ce qu'il comprend les étapes suivantes :

- décharge jusqu'à un niveau de décharge complète de la batterie et mesure de la température Tfindch de la batterie lorsque le niveau de décharge complète est atteint ; et
- charge jusqu'à un niveau de charge complète de la batterie et mesure de la température Tfinch de la batterie lorsque le niveau de charge complète est atteint,

ces deux étapes de charge puis de décharge ou de charge puis de décharge étant consécutives ; et

- calcul de la quantité de charge inaccessible Qdch(Tfindch) à la température de fin de décharge Tfindch suite à l'étape de décharge jusqu'à un niveau de décharge complète de la batterie connaissant la relation donnant la quantité de charge inaccessible Qdch(T) de la batterie en fonction de la température T, et
- calcul de la quantité de charge maximale admissible Qch(Tfinch) par la batterie à la température Tfinch de fin de charge, par la relation Qch(Tfinch) = qch + Qdch(Tfindch), où qch correspondant à la quantité de charges transmises ou restituées à/par la batterie pour passer d'un niveau de décharge complète à un niveau de charge complète ou inversement.

L'invention est plus précisément définie par les revendications.

Ces objets, caractéristiques et avantages de la présente invention seront exposés en détail dans la description suivante d'un mode de réalisation particulier fait à titre non-limitatif en relation avec les figures jointes parmi lesquelles :

La figure 1 représente respectivement l'évolution de la quantité de charge admissible et la quantité de charge inaccessible, en fonction de la température, pour une batterie donnée lors d'une charge et d'une décharge complètes.

La figure 2 représente la mise en oeuvre d'étapes du procédé de gestion d'une batterie selon un mode de réalisation de l'invention.

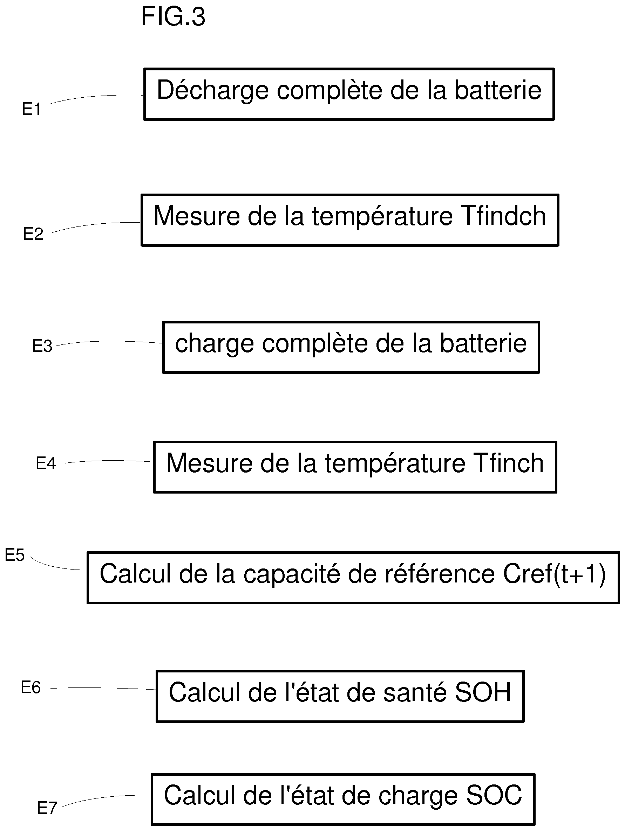

La figure 3 représente un organigramme d'un procédé de gestion de batterie selon un mode d'exécution de l'invention.

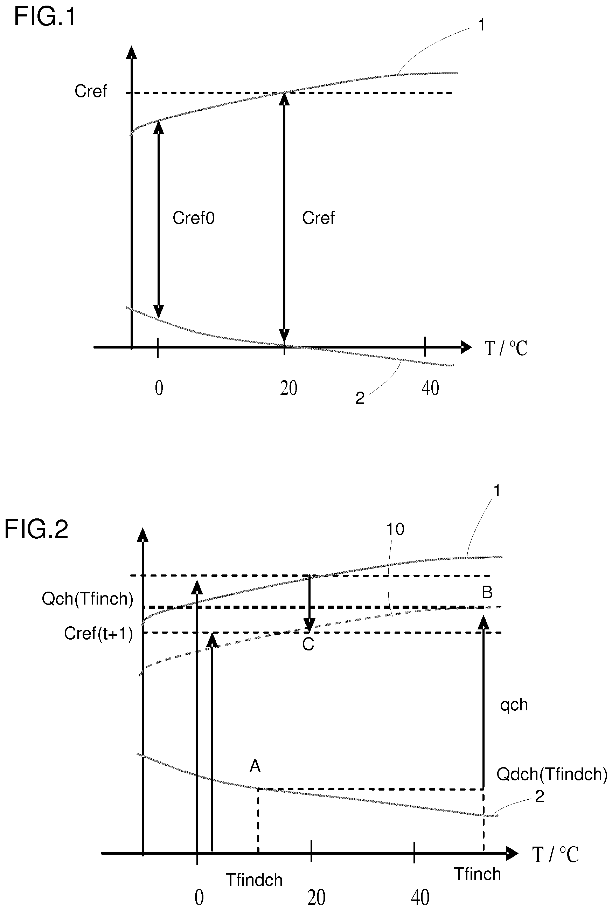

La courbe 1 de la figure 1 représente l'évolution de la quantité de charge admissible par une batterie en fonction de la température. Elle illustre ainsi que, pour une même batterie, déchargée complètement au préalable dans les conditions nominales, lorsqu'elle est chargée dans les mêmes conditions de charge, c'est-à-dire avec les mêmes conditions électriques de courant et tension, pour différentes températures, plus la température est élevée plus la quantité de charge finale restituée est élevée. Par convention, la capacité de référence $C_{ref}$, définie précédemment et prise en compte habituellement, est celle obtenue sur cette courbe 1 pour une température de référence $T_{ref}$, par exemple de 20°C. En remarque, la courbe 1 est définie pour un certain niveau ou profil de courant correspondant au courant de recharge mesuré (ou associé) au moment de la détection du critère de fin de charge. Ainsi, la courbe 1 peut être assimilée à une surface si plusieurs régimes de charge sont pris en compte.

La courbe 2 de la figure 1 représente l'évolution de la quantité de charge inaccessible en décharge d'une batterie en fonction de la température, c'est-à-dire la quantité de charge qui reste stockée dans la batterie après sa décharge complète selon le critère de fin de décharge et qui n'est pas exploitable pour l'alimentation d'un dispositif. Usuellement, les mêmes conditions de décharges et de critère de fin de décharge sont appliqués quelle que soit la température de l'élément lors de la décharge. Néanmoins, selon l'application, il est envisageable d'avoir des conditions et des critères de fin de décharge variables selon la température. Par choix de représentation graphique, cette quantité de charge inaccessible est positionnée sur l'axe d'origine pour la température de référence de 20°C. Il apparait que plus la température augmente, plus cette quantité de charge inaccessible diminue. En remarque similaire à celle faite en référence avec la courbe 1, la courbe 2 est définie pour un certain niveau de courant correspondant au courant de décharge mesuré (ou associé) au moment de la détection du critère de fin de charge. Ainsi, la courbe 2 peut être assimilée à une surface si plusieurs régimes de décharge sont pris en compte.

Ainsi, la capacité de référence $C_{ref}$ d'une batterie est restituée lorsque la batterie est totalement chargée à 20 °C, puis déchargée à cette même température. Si la température évolue, la charge disponible et restituable sera finalement différente, comme $C_{ref0}$ par exemple à 0 °C.

Les deux courbes 1, 2 décrites ci-dessus peuvent être connues lorsque la batterie est dans un état neuf, peuvent être fournies par le fabriquant de la batterie, ou établies empiriquement par des tests de la batterie pour différentes températures et différents régimes de sollicitation électrique (courant ou puissance). Notamment, la capacité de référence initiale $C_{ref0}$ de la batterie à l'état neuf est ainsi connue. Naturellement, ces deux courbes 1, 2 peuvent être remplacées par des abaques donnant quelques valeurs de quantité de charge en fonction de la température, c'est-à-dire quelques points des courbes 1, 2, les autres étant obtenus par une extrapolation, ou par toute autre présentation équivalente de cette connaissance.

Ces courbes 1, 2 sont définies pour des conditions expérimentales spécifiques qu'il est possible de caractériser par trois critères. Le premier critère correspond au profil de sollicitation électrique appliqué aux bornes de la batterie, qui peut être une commande à une ou plusieurs étapes, en courant, tension ou puissance, constantes ou dynamiques. Ce profil est appliqué jusqu'à ce que le critère de fin de charge ou de décharge soit atteint. Le deuxième critère correspond au critère de fin de charge ou de décharge. Il correspond soit au dépassement d'un seuil par une ou plusieurs variables mesurées ou estimées, telles que le courant, la tension, la puissance ou la température, soit au dépassement d'un seuil par des variables internes du système de gestion, telles que le courant ou la puissance autorisée, l'activation d'un mode de fonctionnement spécifique (mode dégradé, fin d'équilibrage...). Le troisième critère correspond aux variables retenues pour référencer la quantité de charge mesurée dans le diagramme. La température, qui définit le positionnement en abscisse, peut être une température, brute ou filtrée, mesurée ou estimée, dans une batterie ou un pack batterie. De plus, le point de mesure est caractéristique soit du régime de courant (ou de puissance) moyen lors de la décharge ou de la charge, soit du régime de courant (ou de puissance) mesuré lors de la détection du critère de fin de décharge ou de charge. A titre d'exemple, les courbes de la figure 2 sont fournies pour des puissances de décharge $P_{findch}$ et de charge $P_{finch}$ atteintes au moment de la détection du critère de respectivement fin de décharge et de charge.

Un mode d'exécution de l'invention repose ainsi sur un procédé de gestion qui estime un état d'une batterie en considérant la température à la fois dans une phase de charge et dans une phase de décharge successives, afin de tenir compte des deux phénomènes représentés par les courbes 1, 2 de la figure 1.

La figure 2 illustre ainsi le procédé de gestion d'une batterie selon un premier mode de réalisation de l'invention. La courbe 1 reste celle explicitée sur la figure 1 pour un instant t. Dans ce mode d'exécution de l'invention, on considère que la performance de la batterie diminue avec le temps, ce qui se manifeste par un simple déplacement en translation verticale vers le bas de cette courbe 1, qui descend ainsi vers une courbe 10 à un instant considéré ultérieur t+1. Selon cette hypothèse, la courbe 10 reste donc parallèle à la courbe 1, ce qui permet de la retracer intégralement dès lors qu'on arrive à définir un seul point de cette courbe. La quantité de charge maximale admissible $Q_{ch}(T)$ en fonction de la température T peut ainsi s'écrire $F(T) + K$, où K est une constante variant en fonction du vieillissement de la batterie, (et pourrait ainsi par exemple s'écrire comme une fonction de l'état de santé SOH de la batterie, $K(SOH)$) et où $F(T)$ est une fonction prédéfinie sensiblement invariante avec le vieillissement de la batterie, qui peut par exemple par convention correspondre la courbe $Q_{ch}(T)$ à l'état neuf de la batterie, auquel cas $K=0$ lorsque la batterie est neuve.

De même, la courbe 2 reste celle décrite sur la figure 1. Dans ce mode d'exécution de l'invention, on considère que cette courbe reste invariable dans le temps.

Le procédé de gestion de la batterie comprend ainsi une première phase comprenant le calcul de la capacité de référence Cref(t+1) à un instant t+1 considéré.

Pour cela, une première étape E1 comprend la décharge complète de la batterie. Le critère de fin de décharge est le critère habituel, donné par le constructeur. Tout critère de fin de décharge peut être appliqué, correspondant à une situation dans laquelle la batterie ne restitue plus ou presque plus d'énergie, dans le système où elle est intégrée. Dans ce premier mode d'exécution, cette décharge se fait dans des conditions nominales sur le plan électrique. Toutes les décharges mises en oeuvre se font dans les mêmes conditions ou dans des conditions similaires, sous condition qu'elles respectent certains critères de similarité (régime moyen, caractéristiques des pics de sollicitation, ratio temps de non-utilisation sur temps d'utilisation). En remarque, cette décharge est mise en oeuvre à partir d'un état initial quelconque de la batterie.

Une seconde étape E2 comprend alors l'enregistrement de la température de fin de décharge Tfindch, ainsi qu'optionnellement du régime de courant de décharge Ifindch atteint lors de la détection du critère de fin de décharge, comme cela sera précisé ultérieurement dans le cadre d'un second mode de réalisation. En fonction de cette température, la quantité de charge restante Qdch(Tfindch) est obtenue au point A sur la courbe 2.

Ensuite, une troisième étape E3 consiste en une recharge complète de la batterie. Cette recharge se fait par exemple aussi avec les conditions électriques nominales définies par le fabriquant de la batterie, le critère de fin de charge étant aussi celui défini par le fabriquant. Naturellement, tout procédé de charge de la batterie peut être utilisé, avec tout critère de fin de charge associé. Selon ce mode d'exécution, toutes les charges mises en oeuvre durant ce procédé de gestion se font dans les mêmes conditions électriques ou dans des conditions similaires sous condition qu'elles respectent certains critères de similarité (régime moyen, caractéristiques des pics de sollicitation, ratio temps de non-utilisation sur temps d'utilisation). Durant cette charge, la charge qch transmise à la batterie est mesurée. Cette charge est par exemple obtenue par la formule suivante, intégrée sur la durée de la phase de charge : qch = ∫ I dit, où I est le courant de charge. Ce courant peut être mesuré par un capteur, ou en variante, il peut être estimé par tout modèle ou toute autre méthode.

Ensuite, une quatrième étape E4 de mesure de la température Tfinch de fin de charge permet d'identifier le point de fin de charge B qui correspond à la quantité de charge Qch(Tfinch) sur la courbe 10, puisque cette valeur est calculée par : Qch(Tfinch) = qch + Qdch(Tfindch). Ce point B appartient à la courbe 10 et comme cela a été vu précédemment, la connaissance d'un seul point permet le tracer de l'intégralité de la courbe 10. Notamment, une fonction Qref peut être introduite pour calculer la capacité de référence à partir d'une quantité de charge admissible Qch(T) à une température T quelconque. Cette fonction Qref reste la même avec le temps puisque la courbe 1 se déplace en translation, comme cela a été explicité précédemment, et elle peut être définie en phase initiale dès lors que la courbe 1 à l'état neuf de la batterie est connue. Ainsi, à tout instant, on a la relation : Cref = Qref (Qch(T),T). En remarque, cette mesure de la température Tfinch de fin de charge est avantageusement réalisée dès le critère de fin de charge atteint.

Ensuite, une cinquième étape E5 comprend alors le calcul de la capacité de référence Cref(t+1) de la batterie à l'instant t+1, en considérant le point C sur cette courbe 10 à la température de référence. Cette détermination peut se présenter à l'aide de la fonction Qref décrite précédemment, par la relation Cref(t+1) = Qref (Qch(Tfinch),Tfinch). En variante, cette même réalité peut s'écrire selon l'approche suivante, explicitée précédemment :

$$Cref(t) = F(Tref) + K(SOH(t)) \text{ et } Cref(t+1) = F(Tref) + K(SOH(t+1))$$

La connaissance du point de fin de charge B permet de connaitre la fonction K(SOH(t+1)).

On note alors que à chaque instant t, Cref (t) = Qch (Tref) - Qdch (Tref). En remarque, dans l'exemple choisi sur la figure 1, la fonction Qdch a été normalisée de sorte que Qdch(Tref) = 0 : dans un tel exemple, la relation précédente devient, pour tout vieillissement de la batterie, Cref = Qch (Tref).

Naturellement, une variante du procédé décrit ci-dessus peut être obtenue en inversant les étapes de charge puis décharge complètes. L'important est de réaliser ces deux étapes de manière consécutive. Dans cette variante, la première étape consiste alors en une charge complète de la batterie, jusqu'à atteindre le critère de fin de charge, à partir de son état initial quelconque. Ensuite, la seconde étape consiste en la mesure de la température Tfinch. La troisième étape consiste en une décharge complète de la batterie, jusqu'à atteindre le critère de décharge. Durant cette décharge complète, la quantité de charge qch restituée par la batterie est mesurée ou estimée. En quatrième étape, la température de fin de décharge Tfindch est mesurée. Ces étapes permettent de même de définir le point B de la courbe 10, puisqu'on peut calculer Qch(Tfinch) = Qdch(Tfindch) + qch. Cette variante du procédé est donc très similaire au procédé décrit plus en détail ci-dessus.

Les étapes de mesure de température et de mesure de courant et/ou tension lors des étapes de charge et de décharge, peuvent être remplacées par des estimations de tout ou partie de ces grandeurs par un modèle de calcul.

Lorsque la capacité de référence est précisément connue à un instant t+1, malgré les conditions de décharge et charge à des températures qui peuvent être quelconques et différentes, le procédé de gestion de la batterie comprend ensuite une seconde phase qui consiste à déterminer l'état de la batterie avec précision.

Ainsi, une étape de calcul de son état de santé E6, aussi appelé SOH pour sa dénomination anglo-saxonne de « State Of Health », peut être mise en oeuvre, en faisant par exemple le ratio entre la capacité de référence Cref(t+1) obtenue et la capacité de référence initiale Crefo à l'état neuf de la batterie.

$$SOH = Cref(t+1) / Crefo$$

De plus, une étape de calcul de son état de charge E7, aussi appelé SOC pour sa dénomination anglo-saxonne de « State Of Charge », peut aussi être mise en oeuvre, par le ratio suivant :

$$SOC = (Qch(Tfinch) - qdch - Qdch(Tf)) / (Qch(Tfinch) - Qdch(T))$$

Où

qdch la quantité de charge restituée par la batterie depuis sa dernière charge complète, cette quantité correspondant à un cumul des quantités de charges restituées et transmises lors de phases partielles de charge et décharge depuis la dernière charge complète,

Qdch(Tf) est la quantité de charge non restituable, à la température estimée en fin de décharge Tf de la batterie. La température Tf peut être paramétrable en ligne ou hors ligne selon l'application,

Qch(Tfinch) est la charge maximale admissible et reçue par la batterie lors de la dernière charge.

En remarque, cette définition de l'état de charge SOC de la batterie permet de tenir compte de sa température T à l'instant considéré, qui peut être choisie comme estimation de la température de fin de décharge Tf dans le calcul ci-dessus, ainsi que de sa température lors de sa précédente charge.

La seconde phase de gestion de la batterie peut aussi permettre de faire des prédictions. En effet, il est possible d'anticiper à tout instant la charge restituable par la batterie pour une certaine température de fonctionnement.

Comme cela a été explicité précédemment, le premier mode d'exécution met en oeuvre des étapes de décharge et charge de la batterie dans des conditions électriques maitrisées et toujours identiques. Un second mode d'exécution de l'invention peut reprendre toutes les étapes précédentes, mais en tenant compte du courant de charge et de décharge de la batterie, en plus de la température. Ainsi, tous les calculs précédents sont modifiés pour intégrer deux paramètres variables, la température et le courant, et des courbes similaires aux courbes 1, 2 de la figure 1 sont modifiées en surface, puisqu'à une dimension supplémentaire, utilisées pour caractériser la variation des quantités de charge en fonction de la température et du courant. Ainsi, ce procédé de gestion de la batterie peut convenir à un environnement dans lequel la température et les courants impliqués sont quelconques. Ce second mode de réalisation est simplement obtenu en ajoutant la variable I de courant dans toutes les équations précédentes dans lesquelles une dépendance de la température est précisée.

Ce procédé de gestion de batterie est adapté à toute batterie, est particulièrement utile à la gestion des batteries disposées dans un environnement thermique non maitrisable, et pour lesquelles une décharge et une charge complète est possible. Il convient donc bien pour un engin de transport électrique, comme une bicyclette, une voiture, un bus, un camion... De manière plus générale, il convient aussi pour toutes applications pour lesquelles les conditions thermiques sont variables (applications stationnaires et/ou nomades). D'autre part, il est compatible avec toute technologie de batterie, particulièrement celle de rendement faradique unitaire ou proche de 1, comme les batteries au Lithium, de type LiFePO4/graphite par exemple. Une extension est possible pour les batteries de type aqueuses (Plomb, NiMH) en intégrant une cartographie de rendement faradique fonction du courant et de la température.

L'invention porte aussi sur une batterie associée à un système de gestion, qui comprend des moyens matériels (hardware) et/ou logiciels (software), au moins un calculateur, pour mettre en oeuvre le procédé de gestion de la batterie détaillé ci-dessus. Ce système de gestion pilote notamment les phases de charge et de décharge de la batterie, les étapes de calcul, de mesure et/ou estimations de grandeurs, comme la température, le courant, la tension, ... Ce système de gestion de la batterie est intégré ou non au sein de la structure de la batterie. Avantageusement, la batterie comprend au moins un capteur de température pour mesurer sa température et la transmettre au calculateur. Le système de gestion comprend de plus une mémoire pour mémoriser toutes les valeurs mesurées et/ou calculées dans les différentes étapes du procédé.

**Revendications**

1. Procédé de gestion d'une batterie **caractérisé en ce qu'**il comprend les étapes suivantes :

> - décharge jusqu'à un niveau de décharge complète (E1) de la batterie et mesure de la température Tfindch de la batterie (E2) lorsque le niveau de décharge complète est atteint ; et
> - charge jusqu'à un niveau de charge complète de la batterie (E3) et mesure de la température Tfinch de la batterie (E4) lorsque le niveau de charge complète est atteint,

ces deux étapes de charge puis de décharge ou de charge puis de décharge étant consécutives ; et

> - calcul de la quantité de charge inaccessible Qdch(Tfindch) à la température de fin de décharge Tfindch suite à l'étape de décharge jusqu'à un niveau de décharge complète de la batterie connaissant la relation donnant la quantité de charge inaccessible Qdch(T) de la batterie en fonction de la température T, et
> - calcul de la quantité de charge maximale admissible Qch(Tfinch) par la batterie à la température Tfinch de fin de charge, par la relation Qch(Tfinch) = qch + Qdch(Tfindch), où qch correspondant à la quantité de charges transmises ou restituées à/par la batterie pour passer d'un niveau de décharge complète à un niveau de charge complète ou inversement.

2. Procédé de gestion d'une batterie selon la revendication 1, dans lequel la courbe d'évolution de la quantité de charge maximale admissible Qch(T) en fonction de la température T se décale en translation verticale vers le bas avec le vieillissement de la batterie, Qch(T) étant égale à F(T) + K, où K est une constante variant en fonction du vieillissement de la batterie et F(T) est une fonction prédéfinie sensiblement invariante avec le vieillissement de la batterie.

3. Procédé de gestion d'une batterie selon l'une des revendications précédentes, **caractérisé en ce qu'**il comprend la mise en oeuvre des étapes suivantes à un instant t :

> - décharge jusqu'à un niveau de décharge complète de la batterie (E1),
> - mesure ou estimation de la température Tfindch en fin de décharge (E2),
> - charge jusqu'à un niveau de charge complète de la batterie et mesure ou estimation de la quantité de charge qch transmise à la batterie (E3),
> - mesure ou estimation de la température Tfinch en fin de charge complète (E4),
> - déduction de la quantité de charge maximale admissible Qch(Tfinch) par la batterie à la température Tfinch de fin de charge, par la relation Qch(Tfinch) = qch + Qdch(Tfindch),

OU

> - charge jusqu'à un niveau de charge complète de la batterie (E1),
> - mesure ou estimation de la température Tfinch en fin de charge (E2),
> - décharge jusqu'à un niveau de décharge complète de la batterie et mesure ou estimation de la quantité de charge qch restituée par la batterie (E3),
> - mesure ou estimation de la température Tfindch en fin de décharge complète (E4),
> - déduction de la quantité de charge maximale admissible Qch(Tfinch) par la batterie à la température Tfinch de fin de charge, par la relation Qch(Tfinch) = qch + Qdch(Tfindch), où Qdch(Tfindch) est la quantité de charge inaccessible de la batterie à la température de fin de décharge Tfindch.

4. Procédé de gestion d'une batterie selon la revendication 2, **caractérisé en ce qu'**il comprend l'estimation, à un instant donné t, de la valeur d'une capacité de référence Cref(t) de la batterie à une température de référence Tref, Cref correspondant à la quantité de charge maximale admissible Qch(Tref) à la température de référence moins la quantité de charges inaccessible Qdch(Tref) à la température de référence, la relation Qch(T) considérée étant telle que Qch(Tfinch) est égale à la valeur précédemment calculée qch + Qdch(Tfindch).

5. Procédé de gestion d'une batterie selon les revendications 3 et 4, **caractérisé en ce qu'**il comprend une étape supplémentaire de déduction (E5) de la capacité de référence Cref(t) à partir de la charge maximale admissible Qch(Tfinch), par une fonction Qref de la manière suivante :

$$Cref(t) = Qref\ (Qch(Tfinch),\ Tfinch).$$

**6.** Procédé de gestion d'une batterie selon la revendication 3 ou 4, **caractérisé en ce que** la mesure ou estimation de la quantité de charges qch transmises, ou restituées, à/par la batterie durant sa charge/décharge est obtenue par la formule suivante, intégrée sur la durée de la phase de charge/décharge de la batterie : $qch = \int I\ dit$, où I est le courant de charge/décharge.

**7.** Procédé de gestion d'une batterie selon l'une des revendications précédentes, **caractérisé en ce qu'**il considère que l'évolution de la quantité de charge inaccessible Qdch(T) de la batterie en fonction de la température T reste constante avec le vieillissement de la batterie.

**8.** Procédé de gestion d'une batterie selon l'une des revendications précédentes, **caractérisé en ce qu'**il comprend une étape de calcul de l'état de santé SOH (E6) de la batterie à un instant t par la formule SOH = Cref(t) / Crefo, où Crefo représente la capacité de référence de la batterie neuve.

**9.** Procédé de gestion d'une batterie selon l'une des revendications précédentes, **caractérisé en ce qu'**il comprend une étape de calcul de son état de charge SOC (E7) par la formule :

$$SOC = (Qch(Tfinch) - qdch - Qdch(Tf))\ /\ (Qch(Tfinch) - Qdch(T))$$

Où

qdch est la quantité de charge restituée par la batterie depuis sa dernière charge complète,
Qdch(Tf) est la quantité de charge non restituable, à la température estimée en fin de décharge Tf de la batterie, qui peut être paramétrable en ligne ou hors ligne selon l'application,
Qch(Tfinch) est la charge maximale admissible et reçue par la batterie lors de sa dernière charge.

**10.** Procédé de gestion d'une batterie selon l'une des revendications précédentes, **caractérisé en ce qu'**il comprend aussi la prise en compte du courant pour déterminer les quantités de charge admissible en fin de charge et inaccessible en fin de décharge.

**11.** Batterie, **caractérisée en ce qu'**elle comprend un calculateur agencé pour mettre en oeuvre le procédé de gestion de batterie selon l'une des revendications précédentes.

**12.** Système de gestion d'une batterie, **caractérisé en ce qu'**il comprend au moins un calculateur agencé pour mettre en oeuvre le procédé de gestion d'une batterie selon l'une des revendications 1 à 10.

**13.** Support informatique lisible par une unité de gestion, **caractérisé en ce qu'**il comprend un programme informatique enregistré comprenant des moyens de codes de programme informatique de mise en oeuvre du procédé de gestion de batterie selon l'une des revendications 1 à 10.

**Patentansprüche**

**1.** Verfahren zur Verwaltung einer Batterie, **dadurch gekennzeichnet, dass** es die folgenden Schritte enthält:

- Entladen bis zu einem Pegel vollständiger Entladung (E1) der Batterie und Messen der Temperatur Tfindch der Batterie (E2), wenn der Pegel vollständiger Entladung erreicht ist; und
- Laden bis zu einem Pegel vollständiger Ladung der Batterie (E3) und Messen der Temperatur Tfinch der Batterie (E4), wenn der Pegel vollständiger Ladung erreicht ist,

wobei diese zwei Ladungs- und dann Entladungsschritte oder Entladungs- und dann Ladungsschritte aufeinander folgen; und

- Berechnen der unzugänglichen Ladungsmenge Qdch(Tfindch) bei der Entladungsende-Temperatur Tfindch nach dem Entladungsschritt bis zu einem Pegel vollständiger Entladung der Batterie in Kenntnis der Beziehung, die die unzugängliche Ladungsmenge Qdch(T) der Batterie abhängig von der Temperatur T angibt, und
- Berechnen der zulässigen maximalen Ladungsmenge Qch(Tfinch) durch die Batterie bei der Ladungsende-Temperatur Tfinch durch die Beziehung Qch(Tfinch) = qch + Qdch(Tfindch), wobei qch der Menge von an die Batterie übertragenen oder von ihr abgegebenen Ladungen entspricht, um von einem Pegel vollständiger Entladung zu einem Pegel vollständiger Ladung oder umgekehrt überzugehen.

2. Verfahren zur Verwaltung einer Batterie nach Anspruch 1, wobei die Entwicklungskurve der zulässigen maximalen Ladungsmenge Qch(T) abhängig von der Temperatur T sich beim Altern der Batterie in senkrechter Translation nach unten verschiebt, wobei Qch(T) gleich F(T) + K ist, wobei K eine Konstante ist, die abhängig vom Altern der Batterie variiert, und F(T) eine vordefinierte Funktion ist, die im Wesentlichen beim Altern der Batterie unveränderlich ist.

3. Verfahren zur Verwaltung einer Batterie nach einem der vorhergehenden Ansprüche, **dadurch gekennzeichnet, dass** es die Durchführung der folgenden Schritte zu einem Zeitpunkt t enthält:

   - Entladen bis zu einem Pegel vollständiger Entladung der Batterie (E1),
   - Messen oder Schätzen der Temperatur Tfindch am Entladungsende (E2),
   - Laden bis zu einem Pegel vollständiger Ladung der Batterie und Messen oder Schätzen der an die Batterie übertragenen Ladungsmenge qch (E3),
   - Messen oder Schätzen der Temperatur Tfinch am Ende der vollständigen Ladung (E4),
   - Ableiten der zulässigen maximalen Ladungsmenge Qch(Tfinch) durch die Batterie bei der Ladungsende-Temperatur Tfinch durch die Beziehung Qch(Tfinch) = qch + Qdch(Tfindch),
   oder
   - Laden bis zu einem Pegel vollständiger Ladung der Batterie (E1),
   - Messen oder Schätzen der Temperatur Tfinch am Ladungsende (E2),
   - Entladen bis zu einem Pegel vollständiger Entladung der Batterie und Messen oder Schätzen der von der Batterie abgegebenen Ladungsmenge qch (E3),
   - Messen oder Schätzen der Temperatur Tfindch am Ende vollständiger Entladung (E4),
   - Ableiten der zulässigen maximalen Ladungsmenge Qch(Tfinch) durch die Batterie bei der Ladungsende-Temperatur Tfinch durch die Beziehung Qch(Tfinch) - qch + Qdch(Tfindch), wobei Qdch(Tfindch) die unzugängliche Ladungsmenge der Batterie bei der Entladungsende-Temperatur Tfindch ist.

4. Verfahren zur Verwaltung einer Batterie nach Anspruch 2, **dadurch gekennzeichnet, dass** es die Schätzung, zu einem gegebenen Zeitpunkt t, des Werts einer Bezugskapazität Cref(t) der Batterie bei einer Bezugstemperatur Tref ist, wobei Cref der zulässigen maximalen Ladungsmenge Qch(Tref) bei der Bezugstemperatur minus die unzugängliche Ladungsmenge Qdch(Tref) bei der Bezugstemperatur ist, wobei die betrachtete Beziehung Qch(T) so ist, dass Qch(Tfinch) gleich dem vorher berechneten Wert qch + Qdch(Tfindch) ist.

5. Verfahren zur Verwaltung einer Batterie nach den Ansprüchen 3 und 4, **dadurch gekennzeichnet, dass** es einen zusätzlichen Schritt der Ableitung (E5) der Bezugskapazität Cref(t) ausgehend von der zulässigen maximalen Ladung Qch(Tfinch) durch eine Funktion Qref in folgender Weise enthält:

$$\text{Cref(t) = Qref (Qch(Tfinch), Tfinch).}$$

6. Verfahren zur Verwaltung einer Batterie nach Anspruch 3 oder 4, **dadurch gekennzeichnet, dass** das Messen oder Schätzen der Menge von von der Batterie während ihres Ladens/Entladens übertragenen oder abgegebenen Ladungen qch durch die folgende Formel erhalten wird, die über die Dauer der Lade-/Entladephase der Batterie integriert wird: qch = ∫ I dt, wobei I der Lade-/Entladestrom ist.

7. Verfahren zur Verwaltung einer Batterie nach einem der vorhergehenden Ansprüche, **dadurch gekennzeichnet, dass** es annimmt, dass die Entwicklung der unzugänglichen Ladungsmenge Qdch(T) der Batterie abhängig von der Temperatur T mit dem Altern der Batterie konstant bleibt.

8. Verfahren zur Verwaltung einer Batterie nach einem der vorhergehenden Ansprüche, **dadurch gekennzeichnet, dass** es einen Schritt des Berechnens des Gesundheitszustands SOH (E6) der Batterie zu einem Zeitpunkt t durch die Formel SOH = Cref(t) / Crefo enthält, wobei Crefo die Bezugskapazität der neuen Batterie darstellt.

9. Verfahren zur Verwaltung einer Batterie nach einem der vorhergehenden Ansprüche, **dadurch gekennzeichnet, dass** es einen Schritt der Berechnung ihres Ladezustands SOC (E7) durch die Formel:

```
SOC = (Qch(Tfinch) - qdch - Qdch(Tf))/(Qch(Tfinch)
- Qdch(T)) enthält,
```

wobei

qdch die von der Batterie seit ihrem letzten vollständigen Laden abgegebene Ladungsmenge ist, Qdch(Tf) die nicht abgebbare Ladungsmenge, bei der geschätzten Temperatur am Entladungsende Tf der Batterie, ist, die je nach der Anwendung online oder offline parametrierbar ist,
Qch(Tfinch) die zulässige maximale Ladung ist und von der Batterie bei ihrem letzten Laden empfangen wurde.

10. Verfahren zur Verwaltung einer Batterie nach einem der vorhergehenden Ansprüche, **dadurch gekennzeichnet, dass** es auch die Berücksichtigung des Stroms enthält, um die Mengen zulässiger Ladung am Ladungsende und unzugänglicher Ladung am Entladungsende zu bestimmen.

11. Batterie, **dadurch gekennzeichnet, dass** sie einen Rechner enthält, der eingerichtet ist, um das Verfahren zur Batterieverwaltung nach einem der vorhergehenden Ansprüche durchzuführen.

12. System zur Verwaltung einer Batterie, **dadurch gekennzeichnet, dass** es mindestens einen Rechner enthält, der eingerichtet ist, um das Verfahren zur Verwaltung einer Batterie nach einem der Ansprüche 1 bis 10 durchzuführen.

13. Datenträger, der von einer Verwaltungseinheit lesbar ist, **dadurch gekennzeichnet, dass** er ein gespeichertes EDV-Programm enthält, das EDV-Programmcodeeinrichtungen zur Durchführung des Verfahrens zur Verwaltung einer Batterie nach einem der Ansprüche 1 ä 10 enthält.

**Claims**

1. A method for managing a battery, **characterized in that** it includes the following steps:

   - discharging the battery to a full discharge level (E1) and measuring the temperature Tfindch of the battery (E2) when the full discharge level is reached; and
   - charging the battery to a full charge level (E3) and measuring the temperature Tfinch of the battery (E4) when the full charge level is reached,

   these two steps of charging then discharging or charging then discharging being consecutive; and

   - calculating the inaccessible charge quantity Qdch(Tfindch) at the end-of-discharge temperature Tfindch following the step of discharging to a level of full discharge of the battery, knowing the relation giving the inaccessible charge quantity Qdch(T) of the battery as a function of the temperature T, and
   - calculating the maximum admissible charge quantity Qch(Tfinch) of the battery at the end-of-charge temperature Tfinch, by the relation Qch(Tfinch) = qch + Qdch(Tfindch), where qch corresponds to the quantity of charges transmitted to or released by the battery to change from a full discharge level to a full charge level or vice versa.

2. Method for managing a battery according to Claim 1, in which the curve showing the change in the maximum admissible charge quantity Qch(T) as a function of the temperature T undergoes a downward vertical translation movement with the ageing of the battery, Qch(T) being equal to F(T) + K, where K is a constant varying as a function of the ageing of the battery and F(T) is a predefined function more or less invariant with the ageing of the battery.

3. Method for managing a battery according to one of the preceding claims, **characterized in that** it includes the implementation of the following steps at a time t:

- discharging the battery to a full discharge level (E1),
- measuring or estimating the end-of-discharge temperature Tfindch (E2),
- charging the battery to a full charge level and measuring or estimating the charge quantity qch transmitted to the battery (E3),
- measuring or estimating the temperature Tfinch at the end of full charging (E4),
- determining the maximum admissible charge quantity Qch(Tfinch) of the battery at the end-of-charge temperature Tfinch, by the relation Qch(Tfinch) = qch + Qdch(Tfindch),

OR

- charging the battery to a full charge level (E1),
- measuring or estimating the end-of-charge temperature Tfinch (E2),
- discharging the battery to a full discharge level and measuring or estimating the charge quantity qch released by the battery (E3),
- measuring or estimating the temperature Tfindch at the end of full discharging (E4),
- determining the maximum admissible charge quantity Qch(Tfinch) of the battery at the end-of-charge temperature Tfinch, by the relation Qch(Tfinch) = qch + Qdch(Tfindch), where Qdch(Tfindch) is the inaccessible charge quantity of the battery at the end-of-discharge temperature Tfindch.

4. Method for managing a battery according to Claim 2, **characterized in that** it includes the estimation, at a given time t, of the value of a reference capacity Cref(t) of the battery at a reference temperature Tref, Cref corresponding to the maximum admissible charge quantity Qch(Tref) at the reference temperature, minus the inaccessible charge quantity Qdch(Tref) at the reference temperature, the relation Qch(T) concerned being such that Qch(Tfinch) is equal to the previously calculated value qch + Qdch(Tfindch).

5. Method for managing a battery according Claims 3 and 4, **characterized in that** it includes an additional step of determining (E5) the reference capacity Cref(t) from the maximum admissible charge Qch(Tfinch), by means of a function Qref in the following manner: Cref(t) = Qref (Qch(Tfinch), Tfinch).

6. Method for managing a battery according to Claim 3 or 4, **characterized in that** the measurement or estimation of the charge quantity qch transmitted to or released by the battery during its charging/discharging is obtained by means of the following formula, integrated over the duration of the battery charging/discharging phase: qch = ∫ I dt, where I is the charging/discharging current.

7. Method for managing a battery according to one of the preceding claims, **characterized in that** it assumes that the change in the inaccessible charge quantity Qdch(T) of the battery as a function of the temperature T remains constant with the ageing of the battery.

8. Method for managing a battery according to one of the preceding claims, **characterized in that** it includes a step of calculating the state of health SOH (E6) of the battery at a time t by means of the formula SOH = Cref(t) / Crefo, where Crefo represents the reference capacity of the new battery.

9. Method for managing a battery according to one of the preceding claims, **characterized in that** it includes a step of calculating its state of charge SOC (E7) by means of the following formula:

$$SOC = (Qch(Tfinch) - qdch - Qdch(Tf)) / (Qch(Tfinch) - Qdch(T))$$

Where

qdch is the charge quantity released by the battery since its last full charging,
Qdch(Tf) is the non-releasable charge quantity, at the estimated end-of-discharge temperature Tf of the battery, which may be parameterizable online or offline according to the application,
Qch(Tfinch) is the maximum admissible charge received by the battery during its last charging.

10. Method for managing a battery according to one of the preceding claims, **characterized in that** it is also includes taking account of the current in order to determine the admissible charge quantities at the end of charging and the inaccessible charge quantities at the end of discharging.

11. Battery, **characterized in that** it includes a computer arranged to implement the battery management method according to one of the preceding claims.

12. Battery management system, **characterized in that** it includes at least one computer arranged to implement the battery management method according to one of Claims 1 to 10.

13. Computer medium readable by a management unit, **characterized in that** it includes a recorded computer program including computer program code means for carrying out the battery management method according to one of Claims 1 to 10.

FIG.1

FIG.2

# FIG.3

E1 — Décharge complète de la batterie

E2 — Mesure de la température Tfindch

E3 — charge complète de la batterie

E4 — Mesure de la température Tfinch

E5 — Calcul de la capacité de référence Cref(t+1)

E6 — Calcul de l'état de santé SOH

E7 — Calcul de l'état de charge SOC

**RÉFÉRENCES CITÉES DANS LA DESCRIPTION**

**Documents brevets cités dans la description**

- US 20070236183 A